# EUROPEAN PATENT SPECIFICATION

(11) **EP 1 169 401 B1**
(45) Date of publication and mention of the grant of the patent: **08.01.2003**
(21) Application number: 00914134.2
(22) Date of filing: 14.03.2000
(51) Int. Cl.: C09D 201/02, G03F 7/027, C09D 4/00

(54) **RADIATION CURABLE COATING COMPOSITION COMPRISING A SECONDARY CURING AGENT**
DURCH STRAHLUNG HÄRTBARE ÜBERZUGSZUSAMMENSETZUNG DIE EIN SEKUNDÄRES HÄRTUNGSMITTEL ENTHÄLT
COMPOSITION DE REVETEMENT DURCISSABLE PAR RAYONNEMENT CONTENANT UN AGENT DE DURCISSEMENT SECONDAIRE

(30) Priority: 16.03.1999 EP 99200807
(43) Date of publication of application: 09.01.2002
(73) Proprietor: Akzo Nobel N.V., 6824 BM Arnhem (NL)
(72) Inventor: KJELLQVIST LINDELL, Ann, Kerstin, Birgitta, S-216 18 Malmö (SE); KRUITHOF, Klaas, Jan, Hendrik, NL-3906 BK Veenendaal (NL); LANSBERGEN, Adrianus, Jozefus, Hendricus, NL-6862 WV Oosterbeek (NL); KLAASEN, Robert, Paul, NL-1060 PW Amsterdam (NL)
(74) Representative: Schalkwijk, Pieter Cornelis
(86) International application number: EP0002281
(87) International publication number: WO00055272

(56) References cited:
- EP-A- 0 447 845
- DE-A- 3 306 093
- US-A- 5 460 857
- PATENT ABSTRACTS OF JAPAN vol. 12, no. 28 (C-471), 27 January 1988 (1988-01-27) & JP 62 179519 A (MATSUSHITA ELECTRIC IND CO LTD), 6 August 1987 (1987-08-06) & DATABASE WPI Week 8737 Derwent Publications Ltd., London, GB; AN 260120
- PATENT ABSTRACTS OF JAPAN vol. 14, no. 356 (C-745), 2 August 1990 (1990-08-02) & JP 02 129213 A (WASHIN KAGAKU KOGYO KK), 17 May 1990 (1990-05-17) & DATABASE WPI Week 9026 Derwent Publications Ltd., London, GB; AN 196898
- PATENT ABSTRACTS OF JAPAN vol. 12, no. 316 (C-524), 26 August 1988 (1988-08-26) & JP 63 085030 A (MITSUBISHI PETROCHEM) & DATABASE WPI Week 8821 Derwent Publications Ltd., London, GB; AN 143632
- PATENT ABSTRACTS OF JAPAN vol. 16, no. 137 (M-1231), 7 April 1992 (1992-04-07) & JP 03 297638 A (HITACHI CHEM), 27 December 1991 (1991-12-27) & DATABASE WPI Week 199230 Derwent Publications Ltd., London, GB; AN 59282

## Description

The present invention relates to a radiation curable coating composition comprising a secondary curing agent.

Such a composition is known, e.g., from US 4,128,600, wherein a radiation curable coating composition is disclosed which comprises a saturated polyol and a reactive oligomer selected from the group consisting of fully substituted poly(meth)acrylates of poly-functional alcohols. This known composition additionally comprises a polyisocyanate.

A primary concern in the coating industry is the need to reduce the emission of volatile hydrocarbons into the air.
In classic heat curing coating compositions a high-viscous film forming resin is mixed with a solvent to aid the manufacture of the coating composition and to facilitate the application of these compositions to substrates. During curing of the coating the solvent is driven off by the thermal energy used to effect the curing. A considerable amount of thermal energy is thus used to drive off the solvent. However, the thermal energy may cause considerable side effects in the coating or on the substrate, in particular when the substrate is heat sensitive.
To solve this problem, it was suggested to use a radiation sensitive reactive solvent to reduce the viscosity of the film forming resin. Upon radiation, these reactive solvents react with each other or with the film forming resin and a coating of good quality can be obtained. Optionally, the composition may comprise a crosslinker which reacts with the film forming resin.

A problem with these coatings on porous substrates is the penetration of the coating composition into the pores, in particular when radiation is used to cure the coating. Since the radiation does not reach these areas, uncured coating material is the result. This can give health, safety, and environmental problems, e.g., when the substrate is cut or sanded. These problems occur even years after the lacquer has been applied. The same problems can be found in other substrates comprising shadow areas, e.g. in 3-D substrates, or when a pigmented lacquer is used.

In particular low-molecular weight material, viz. monomers and oligomers which are used as reactive oligomers, gives the biggest problem with penetration. Well-known acrylic diluents, e.g., tripropylene glycol diacrylate (TPGDA), hexanediol diacrylate (HDDA), and hydroxyethyl methacrylate (HEMA) are irritant and sensitising and will never react if they are not reached by the UV light.

To overcome the problems caused by the not yet reacted diluent, it is known in the art to add a secondary curing agent. In general, a secondary curing agent will have a lower reactivity towards the main film forming component(s) than the primary curing agent.
A well-known side effect of the addition of a secondary curing agent to a radiation curable composition is a reduction of the pot life of the thus obtained coating composition, since the secondary curing agent will also react in the absence of radiation.
(Poly)lsocyanates are often used as a secondary curing agent if the lacquer is formulated in such a way that only OH-functional acrylic reactive oligomers are used, for instance HEMA. However, the use of isocyanates is not attractive and it limits the formulation possibilities of the lacquer.
Peroxy curing is not preferred, mainly due to handling problems such as short pot life.
In the market nowadays lacquer compositions comprising a carboxy compound and an epoxy secondary curing agent can be found. A major drawback of this coating formulation is the required balance between reactivity and coating performance. With these systems a fair coating performance can only be obtained after long reaction times. If accelerators for the reaction are incorporated into the formulation, a poor coating performance is observed.
Moisture curing silanes can also be used as secondary curing agents but require controlled amounts of water to cure. In practice such a controlled environment is often hard to maintain.

DE 33 06 093 discloses a radiation curable binder emulsion prepared by reacting a secondary amine with part of the ethylenically unsaturated double bonds of a polymeric material. In this reaction, the secondary amine is not a secondary curing agent. Further, the mixing of a radiation curable lacquer having unsaturated double bonds with a compound comprising an electron donor-functional group is not mentioned.
EP 0 447 945 discloses the preparation of an amine modified urethane acrylate binder. In this reaction, the amine compound is reacted with an unsaturated double bond in the urethane acrylate binder. This reaction is one of the steps in the preparation of a radiation curable coating composition. In this reaction, the secondary amine is not a secondary curing agent. Further, the mixing of a radiation curable lacquer having unsaturated double bonds with a compound comprising an electron donor-functional group is not mentioned.

The present invention relates to a radiation curable coating composition which presents a solution to the above-mentioned problems, viz. a radiation curable coating composition which is obtained by mixing (A) a radiation curable lacquer comprising a compound having an olefinically unsaturated double bond with (B) a compound comprising an electron donor-functional group capable of reacting with the compound, which is present in lacquer (A) having an olefinically unsaturated double bond, in the absence of electromagnetic radiation having a wavelength λ ≤ 500 nm.

It was found that a broad range of radiation curable lacquers comprising unsaturated polymer resins, optionally including reactive oligomers, and compounds comprising an electron donor-functional group can be used in the composition according to the present invention.

The amount of compound B (i.e. the compound comprising an electron donor-functional group) that is mixed with the radiation curable lacquer should be such that a balance is found between the reactivity of the electron donor-functional group towards the radiation curable lacquer and the stability of the coating composition. In general, good results are obtained when 1 - 20 pbw of compound B are mixed with 100 pbw of the radiation curable lacquer composition A.

Within the framework of the present invention, a radiation curable coating composition is a coating composition which is cured by using electromagnetic radiation having a wavelength λ ≤ 500 nm. Examples of electromagnetic radiation having a wavelength λ ≤ 500 nm are, e.g., UV radiation or electron beam radiation.

Within the framework of the present invention the radiation curable lacquer (A) is a coating composition that is capable of curing and film forming without the necessity to add any further components and that will provide a coating with good properties, albeit that the cured coating then may comprise unreacted monomers and/or oligomers .
Preference is given to the use of a lacquer comprising UV curing unsaturated polymer resins, such as UV curable unsaturated polyester resins, UV curable unsaturated epoxy resins, UV curable unsaturated urethane resins, and UV curable unsaturated acrylic resins or mixtures thereof.

Examples of unsaturated polymer resins that can be used in the coating composition according to the present invention are Laromer® 8799 (ex BASF) Craynor® 104 (ex Cray Valley), Ebercryl® 210 (ex UCB), Crodamer® UVE 150 (ex Croda) or Actilane® 578 (ex Akcros).

To obtain a suitable application viscosity of the coatings, well-known UV curable monomers can be added as viscosity reducing agents and reactive oligomers. Examples of these reactive oligomers are tripropylene glycol diacrylate (TPGDA), hexanediol diacrylate (HDDA), and hydroxyethyl methacrylate (HEMA).

Good results are obtained when the compound comprising an electron donor-functional group is an amine- or thio-functional compound.
If an amine compound is used as compound comprising an electron donor-functional group, special attention should be paid to the reactivity of the amine compound towards the radiation curable lacquer. In general, primary amine compounds show a high reactivity towards unsaturated double bonds, leading to a relatively short pot life. The reactivity can be decreased by sterically hindering, shielding or capping the primary amine group.
In general, good results are obtained when the amine-functional compound is a secondary amine compound. These compounds show a very good balance between reactivity and stability. Examples of amine-functional compounds which give very good results in the coating composition according to the present invention are aminoethyl ethanolamine, aminoethyl piperazine, α,ω-diaminopropylene glycol (Jeffamine D400), diethylene triamine, dipropylene triamine, trimethylhexane(1,6)diamine (mixture of 2,2,4 and 2,4,4 isomers), and 3-aminopropyltriethoxysilane (Dynasil AMEO-T ex Hüls).

Examples of thio-functional compounds that can be used in the coating composition according to the present invention are the esters of thioglycolic acid, 1-mercaptopropionic acid or 2-mercaptopropionic acid with polyols, such as glycols, pentaerythritol, di-pentaerythritol, and trimethylol propane. Specific examples of suitable thiols are ethylene glycol bis (thioglycolate), ethylene glycol bis (2-mercaptopropionate), pentaerythritol tetrakis (thiogtycolate), and pentaerythritol tetrakis (3-mercapto propionate).

Due to the presence of a compound comprising an electron donor-functional group capable of reacting in the absence of radiation with the compound having an olefinically unsaturated double bond in the coating composition according to the present invention, a secondary curing mechanism occurs which reduces the amount of uncured reactive species. This can be shown by several well-known analytical techniques, e.g., by extraction analysis.
If the electron donor-functional group is an amine- or thio-functional group, the compound comprising such groups undergoes a Pseudo Michael Addition (PMA) to the unreacted c=c bonds which are present in the lacquer composition. The double bonds not cured by the UV light will then be cured by PMA. In principle, there is no limitation of the formulation possibilities.

In general, the reaction between the electron donor-functional group and the unsaturated double bond will start when components (A) and (B) are mixed. When the electron donor-functional group is an amine- or thio-functional group, in particular when the amine-functional group is a secondary amine group, a very good balance is obtained between the stability of the coating formulation and its reactivity. Without any special precautions, with these compositions a pot life between 6 and 8 hours can be obtained.

To further improve the film properties of the coating composition according to the present invention, a radiation curable group can be incorporated into the compound comprising an electron donor-functional group. Particularly good results can be obtained if the radiation curable group is incorporated by reacting a so-called bulky unsaturated monomer with the compound comprising the electron donor-functional group. For example, by reacting DCPA (dicyclopentenyl acrylate, i.e. a bulky unsaturated monomer) with DETA (diethylenetriamine) or DPTA (dipropylenetriamine) an amine-functional electron donor compound is obtained with two UV curable groups, viz. the two dicyclopentenyl groups. This so-called dual-cure amine-functional compound can react with the unreacted c=c bonds which are present in the coating composition and can play a role in the curing of the coating when the coating is irradiated by actinic rays.

It was found that the radiation reactivity of the coating compositions according to the present invention is improved in comparison to known radiation curable coating compositions.
Further, with the composition according to the present invention, an improved through-cure and adhesion to the substrate was found in comparison to similar known coating compositions.
In addition, it was found that also the abrasion resistance of the coating compositions according to the present invention is improved in comparison to known radiation curable coating compositions, for example radiation curable lacquers comprising a compound having an olefinically unsaturated double bond but which do not contain a compound comprising an electron donor-functional group capable of reacting with the compound, which is present in lacquer (A) having an olefinically unsaturated double bond.

The coating compositions according to the present invention are particularly suited to be used as a radiation curable coating for substrates comprising shadow areas, such as 3D substrates or porous substrates like paper, wood or MDF, but they can also be used for the coating of metal or plastic substrates. Further, the coating compositions according to the present invention are very well suited to be used in (heavily) pigmented radiation curable coating compositions.

Additives and fillers that are known to those skilled in the art can be added to the coating compositions according to the present invention, e.g., diluents, defoamers, levelling agents, antisettling agents, photoinitiators, rheology modifiers, and pigments.

The invention will be elucidated with reference to the following examples. These are intended to illustrate the invention but are not to be construed as limiting in any manner the scope thereof.

### Examples

### Example 1

An abrasion resistant UV curable basecoat is prepared by combining 61 parts by weight of an polyester acrylate binder, 30 parts by weight of an acrylic diluent (25,3 parts by weight of which are tripropylene glycol diacrylate [TPGDA]), and 9 parts by weight of other components such as photoinitiators, defoamers, levelling agents, and fillers.

### Example 2

A UV curable basecoat for furniture is prepared by combining 34,6 parts by weight of a polyester acrylate binder, 44,8 parts by weight of a polyether acrylate binder, and 17 parts by weight of other components such as photoinitiators, defoamers, levelling agents, and fillers.

### Example 3

Several amine-functional resins are prepared on the basis of an acrylate and a secondary amine. Optionally TPGDA is added. The resins are prepared by slowly adding the acrylate (DCPA: dicyclopentenylacrylate) to the amine. When TPGDA is added, it is added before the acrylate. The obtained mixture is cooled with ice/water in order to keep the temperature below 15°C. Approximately one hour after the addition, the reaction is completed. This can be checked by Proton NMR on acrylic protons, which should no longer be present. The following amine-functional resins were prepared:

| Resin no. | Type of amine | Molar ratio amine/DCPA/TPGDA |
|---|---|---|
| 3a | AEEA | 1:1 |
| 3b | AEEA | 1:1,25 |
| 3c | AEEA | 1:1,5 |
| 3d | AEP | 1:1 |
| 3e | DETA | 4:5:1,5 |
| 3f | DPTA | 4:5:1,5 |
| 3g | TMHDA | 4:5:1,5 |
| Wherein AEEA stands for aminoethyl ethanolamine AEP stands for aminoethyl piperazine DETA stands for diethylene triamine DPTA stands for dipropylene triamine TMHDA stands for trimethylhexane(1,6)diamine (mixture of 2,2,4 and 2,4,4 isomers) | | |

For comparison, a solution was prepared of 70 wt.% Desmodur N (a polyisocyanate) in 30 wt.% ethylacetate. In the following, this resin is indicated as resin 3h.

### Example 4

The curing time of some lacquer compositions was measured using a transport belt and a 80 W/cm² Hg lamp. The lacquer was applied to a substrate that was placed on the belt. The substrate was passed under the Hg lamp. The speed of the belt was adjusted to get a fully cured lacquer after one passage under the lamp. The higher the belt speed, the shorter the curing time of the lacquer.
In this way the effect of the addition of some resins of Example 3 on the reactivity of the lacquer of Example 1 was measured.

| Lacquer composition | Belt speed (m/min) |
|---|---|
| Example 1 | 7 |
| Example 1 + 6,45 wt.% of resin 3a | > 25 |
| Example 1 + 6,45 wt.% of resin 3b | 23 |
| Example 1 + 6,45 wt.% of resin 3c | 20 |
| Example 1 + 6,45 wt.% of resin 3d | 23 |
| Example 1 + 6,45 wt.% of resin 3e | 19 |
| Example 1 + 6,45 wt.% of resin 3f | 22 |
| Example 1 + 6,45 wt.% of resin 3g | 13 |
| Example 1 + 6,45 wt.% of resin 3h | 8 |

### Example 5

Some resins of Example 3 are added to the lacquer of Example 1. The resulting lacquer is applied with a roller on oak parquet panels at 25-30 g/cm² and precured using Hg lamps with 80 W/cm² on a belt at a speed of 10 m/min. A second lacquer layer is applied at 25-30 g/cm² and cured at 5 m/min.
The amount of acrylic diluent in the obtained lacquer layer is determined by peeling 1 dm² with a depth of 2-3 mm off the panels and extraction with dichloromethane followed by gaschromatographic measurements (GC/FID). In this way the total amount of acrylic diluents in the lacquer is measured.
The following results are found:

| Lacquer composition | Acrylic diluents mg/dm² |
|---|---|
| Example 1 | 14 |
| Example 1 + 6,45 wt.% of resin 3a | 9,5 |
| Example 1 + 6,45 wt.% of resin 3b | 7 |
| Example 1 + 6,45 wt.% of resin 3c | 7 |
| Example 1 + 6,45 wt.% of resin 3d | 7 |
| Example 1 + 10,0 wt.% of resin 3e | 10 |
| Example 1 + 10,0 wt.% of resin 3f | 7 |
| Example 1 + 10,0 wt.% of resin 3g | 10 |
| Example 1 + 9,2 wt.% of resin 3h | 12,5 |

### Example 6

Example 5 is repeated using the lacquer of Example 2. This lacquer is applied on MDF substrates.
The following results are found:

| Lacquer composition | Acrylic diluents mg/dm² |
|---|---|
| Example 2 | 5,5 |
| Example 2 + 10,0 wt.% of resin 3a | 2,9 |
| Example 2 + 10,0 wt.% of resin 3b | 1,1 |
| Example 2 + 10,0 wt.% of resin 3e | 2,6 |
| Example 2 + 10,0 wt.% of resin 3f | 2,7 |
| Example 2 + 10,0 wt.% of resin 3h | 4,2 |

### Example 7

The abrasion resistance of panels prepared according to Example 5 is measured using the falling sand method SIS 923509.
The following results are found:

| Lacquer composition | Abrasion mg/100 rev. |
|---|---|
| Example 1 | 5,2 |
| Example 1 + 10,0 wt.% of resin 3a | 1,5 |
| Example 1 + 10,0 wt.% of resin 3d | 1,5 |
| Example 1 + 10,0 wt.% of resin 3e | 1,7 |
| Example 1 + 10,0 wt.% of resin 3g | 1,7 |
| Example 1 + 9,2 wt.% of resin 3h | 2,6 |

## Claims

1. Radiation curable coating composition which is formed by mixing (A) a radiation curable lacquer comprising a compound having an olefinically unsaturated double bond with a secondary curing agent (B), wherein said secondary curing agent is a compound comprising an electron donor-functional group capable of reacting with the compound, which is present in lacquer (A) having an olefinically unsaturated double bond, in the absence of electromagnetic radiation having a wavelength λ ≤ 500 nm.

2. Radiation curable coating composition according to claim 1, **characterised in that** the compound comprising the electron donor-functional group is an amine- or thio-functional compound.

3. Radiation curable coating composition according to claim 1, **characterised in that** the amine-functional compound is a secondary amine compound.

4. Radiation curable coating composition according to claims 1-3, **characterised in that** compound (B) also incorporates a radiation curable-functional group.

5. Process for coating a substrate with a radiation curable coating composition wherein prior to application to the substrate the composition is formed by mixing (A) a radiation curable lacquer comprising a compound having an olefinically unsaturated double bond with a secondary curing agent (B), wherein said secondary curing agent is a compound comprising an electron donor-functional group capable of reacting with the compound, which is present in lacquer (A) having an olefinically unsaturated double bond, in the absence of electromagnetic radiation having a wavelength λ ≤ 500 nm.

6. Process according to claim 5, **characterised in that** the compound comprising the electron donor-functional group is an amine- or thio-functional compound.

7. Process according to claim 5, **characterised in that** the amine-functional compound is a secondary amine compound.

8. Process according to any one of claims 5 - 7, **characterised in that** compound (B) also incorporates a radiation curable-functional group.

9. Process according to any one of claims 5-8, **characterised in that** the substrate is a substrate comprising shadow areas.

10. Use of the coating composition according to any one of claims 1 to 4 for the coating of substrates comprising shadow areas.

## Patentansprüche

1. Strahlungshärtbare Beschichtungszusammensetzung, die gebildet wird durch Mischen von (A) einem strahlungshärtbaren Lack, der eine Verbindung mit einer olefinisch ungesättigten Doppelbindung umfasst, mit einem sekundären Härtungsmittel (B), wobei das sekundäre Härtungsmittel eine Verbindung ist, die eine Elektronendonor-funktionelle Gruppe umfasst, die mit der in Lack (A) vorhandenen Verbindung mit der olefinisch ungesättigten Doppelbindung reagieren kann, in Abwesenheit von elektromagnetischer Strahlung mit einer Wellenlänge λ ≤ 500 nm.

2. Strahlungshärtbare Beschichtungszusammensetzung gemäß Anspruch 1, **dadurch gekennzeichnet, dass** die Verbindung, die die Elektronendonor-funktionelle Gruppe umfasst, eine amin- oder thiofunktionelle Verbindung ist.

3. Strahlungshärtbare Beschichtungszusammensetzung gemäß Anspruch 1, **dadurch gekennzeichnet, dass** die aminfunktionelle Verbindung eine sekundäre Aminverbindung ist.

4. Strahlungshärtbare Beschichtungszusammensetzung gemäß den Ansprüchen 1-3, **dadurch gekennzeichnet, dass** Verbindung (B) auch eine strahlungshärtbare funktionelle Gruppe umfasst.

5. Verfahren zur Beschichtung eines Substrats mit einer strahlungshärtbaren Beschichtungszusammensetzung, wobei die Zusammensetzung vor dem Auftragen auf das Substrat gebildet wird durch Mischen von (A) einem strahlungshärtbaren Lack, der eine Verbindung mit einer olefinisch ungesättigten Doppelbindung umfasst, mit einem sekundären Härtungsmittel (B), wobei das sekundäre Härtungsmittel eine Verbindung ist, die eine Elektronendonor-funktionelle Gruppe umfasst, die mit der in Lack (A) vorhandenen Verbindung mit der olefinisch ungesättigten Doppelbindung reagieren kann, in Abwesenheit von elektromagnetischer Strahlung mit einer Wellenlänge λ ≤ 500 nm.

6. Verfahren gemäß Anspruch 5, **dadurch gekennzeichnet, dass** die Verbindung, die die Elektronendonor-funktionelle Gruppe umfasst, eine amin- oder thiofunktionelle Verbindung ist.

7. Verfahren gemäß Anspruch 5, **dadurch gekennzeichnet, dass** die aminfunktionelle Verbindung eine sekundäre Aminverbindung ist.

8. Verfahren gemäß einem der Ansprüche 5-7, **dadurch gekennzeichnet, dass** Verbindung (B) auch eine strahlungshärtbare funktionelle Gruppe umfasst.

9. Verfahren gemäß einem der Ansprüche 5-8, **dadurch gekennzeichnet, dass** das Substrat ein Substrat mit Schattenbereichen ist.

10. Verwendung der Beschichtungszusammensetzung gemäß einem der Ansprüche 1 bis 4 zur Beschichtung von Substraten mit Schattenbereichen.

## Revendications

1. Composition de revêtement durcissable par rayonnement qui est formée en mélangeant (A) une laque durcissable par rayonnement comprenant un composé contenant une double liaison à insaturation oléfinique avec un agent de durcissement secondaire (B), dans laquelle ledit agent de durcissement secondaire est un composé comprenant un groupe fonctionnel donneur d'électrons capable de réagir avec le composé qui est présent dans la laque (A) contenant une double liaison à insaturation oléfinique, en l'absence d'un rayonnement électromagnétique ayant une longueur d'onde λ ≤ 500 nm.

2. Composition de revêtement durcissable par rayonnement selon la revendication 1, **caractérisée en ce que** le composé comprenant le groupe fonctionnel donneur d'électrons est un composé à fonction amine ou thio.

3. Composition de revêtement durcissable par rayonnement selon la revendication 1, **caractérisée en ce que** le composé à fonction amine est une amine secondaire.

4. Composition de revêtement durcissable par rayonnement selon les revendications 1 à 3, **caractérisée en ce que** le composé (B) contient également un groupe fonctionnel durcissable par rayonnement.

5. Procédé de revêtement d' un substrat avec une composition durcissable par rayonnement, dans lequel, avant l'application au substrat, la composition est formée en mélangeant (A) une laque durcissable par rayonnement comprenant un composé contenant une double liaison à insaturation oléfinique avec un agent de durcissement secondaire (B), dans laquelle ledit agent de durcissement secondaire est un composé comprenant un groupe fonctionnel donneur d'électrons capable de réagir avec le composé qui est présent dans la laque (A) contenant une double liaison à insaturation oléfinique, en l'absence d'un rayonnement électromagnétique ayant une longueur d'onde λ ≤ 500 nm.

6. Procédé selon la revendication 5, **caractérisé en ce que** le composé comprenant le groupe fonctionnel donneur d'électrons est un composé à fonction amine ou thio.

7. Procédé selon la revendication 5, **caractérisé en ce que** le composé à fonction amine est une amine secondaire.

8. Procédé selon l'une quelconque des revendications 5 à 7, **caractérisé en ce que** le composé (B) contient également un groupe fonctionnel durcissable par rayonnement.

9. Procédé selon l'une quelconque des revendications 5 à 8, **caractérisé en ce que** le substrat est un substrat comprenant des zones d' ombre.

10. Utilisation de la composition de revêtement selon l'une quelconque des revendications 1 à 4 pour le revêtement de substrats comprenant des zones d'ombre.
